(19) **Europäisches Patentamt European Patent Office Office européen des brevets**

(11) **EP 1 902 453 B1**

(12) **FASCICULE DE BREVET EUROPEEN**

(45) Date de publication et mention
de la délivrance du brevet:
**12.01.2011 Bulletin 2011/02**

(21) Numéro de dépôt: **06777625.2**

(22) Date de dépôt: **06.07.2006**

(51) Int Cl.:
***H01G 5/16*** (2006.01)

(86) Numéro de dépôt international:
**PCT/EP2006/063980**

(87) Numéro de publication internationale:
**WO 2007/006729 (18.01.2007 Gazette 2007/03)**

(54) **DISPOSITIF CAPACITIF A VOLUME CAPACITIF OPTIMISE**

KAPAZITIVE VORRICHTUNG MIT OPTIMIERTEM KAPAZITIVEM VOLUMEN

CAPACITIVE DEVICE WITH OPTIMIZED CAPACITIVE VOLUME

(84) Etats contractants désignés:
**AT BE BG CH CY CZ DE DK EE ES FI FR GB GR
HU IE IS IT LI LT LU LV MC NL PL PT RO SE SI
SK TR**

(30) Priorité: **08.07.2005 FR 0552111**

(43) Date de publication de la demande:
**26.03.2008 Bulletin 2008/13**

(73) Titulaire: **Commissariat à l'Énergie Atomique
et aux Énergies Alternatives
75015 Paris (FR)**

(72) Inventeurs:
• **DESPESSE, Ghislain
F-38120 Saint Egreve (FR)**
• **CHAILLOUT, Jean-Jacques
F-38960 Saint-Etienne de Crossey (FR)**
• **JAGER, Thomas
F-38000 Grenoble (FR)**

(74) Mandataire: **Poulin, Gérard et al
BREVALEX
3, rue du Docteur Lancereaux
75008 Paris (FR)**

(56) Documents cités:
**WO-A-02/19509          US-A- 5 025 346
US-A- 5 563 343          US-A- 5 640 133
US-A- 6 133 670          US-A1- 2003 106 372
US-A1- 2004 246 654      US-A1- 2005 013 087**

**Description**

DOMAINE TECHNIQUE ET ART ANTÉRIEUR

La présente invention se rapporte principalement à un dispositif capacitif à volume capacitif optimisé, notamment utilisé pour réaliser des accéléromètres, gyromètres, et sismomètres.

Les dispositifs capacitifs comportent au moins deux peignes capacitifs interdigités formant condensateur, l'un étant généralement fixe et l'autre mobile. Chaque peigne comporte des doigts qui sont interposés avec jeu entre les doigts de l'autre peigne. Les doigts de chaque peigne sont généralement de forme rectangulaire et s'interposent entre deux doigts de l'autre peigne qui délimitent également un espace de forme rectangulaire. La distance séparant deux doigts directement adjacents, est appelée entrefer. Un tel dispositif est décrit dans le document WO 02/19509.

Ces dispositifs permettent la conversion d'une énergie mécanique, le déplacement relatif des peignes l'un par rapport à l'autre par exemple par vibration, en une énergie électrique. Ces dispositifs permettent également la conversion d'une énergie électrique en énergie mécanique, par effet électrostatique. Ainsi en appliquant une différence de potentiel entre les doigts de deux peignes différents, on provoque le déplacement d'un peigne par rapport à l'autre.

Il est particulièrement intéressant de réduire la taille de ce type de dispositif, car ceci permet d'augmenter la capacité volumique de la structure de conversion.

Cependant, la réduction de la taille du dispositif entraîne une diminution du déplacement relatif entre les peignes, ce qui, dans le cas de la récupération d'énergie mécanique de vibration, induit une réduction de l'énergie récupérable.

Actuellement, les structures électrostatiques utilisant la variation d'entrefer entre deux éléments ayant un mouvement relatif sensiblement selon une direction rectiligne, comportent généralement des doigts orthogonaux à la direction de déplacement. Or les possibilités d'augmenter la capacité volumique de ce type de structure en gardant une amplitude de déplacement importante sont limitées. On peut affiner les doigts de chaque peigne, mais cet amincissement doit tenir compte de la tenue à l'effort des doigts, engendré par la force électrostatique ou la force d'inertie propre des doigts.

C'est par conséquent un but de la présente invention d'offrir un dispositif capacitif ayant une capacité volumique augmentée pour un volume et une amplitude de déplacement donnés.

EXPOSÉ DE L'INVENTION

Le but précédemment énoncé est atteint grâce à un dispositif capacitif comportant au moins un premier et un deuxième peignes comportant des doigts dont les surface en regard sont inclinées par rapport à un plan orthogonal à la direction de déplacement du ou des peignes.

Ainsi, les surfaces en regard sont augmentées, ce qui, pour un même débattement, permet d'avoir à la fois une augmentation de la capacité volumique et une augmentation de la force électrostatique pour une tension donnée.

La présente invention permet avantageusement de réduire l'influence des capacités parasites parallèles extérieures provenant, par exemple, de l'électronique de gestion, grâce à une capacité du dispositif plus élevée.

La présente invention a alors principalement pour objet un dispositif capacitif tel que défini par les caractéristiques de la revendication 1, ce dispositif comportant au moins un premier et un deuxième peignes, munis respectivement de doigts interdigités, lesdits peignes étant aptes à être mobiles l'un par rapport à l'autre selon au moins une première direction déterminée, au moins un doigt du premier peigne comportant une face en regard d'une face d'un doigt du deuxième peigne caractérisé en ce que ladite face du doigt du premier peigne et ladite face du doigt du deuxième peigne sont inclinées par rapport à un plan orthogonal à la première direction de déplacement des peignes, le plan étant défini par des deuxième et troisième directions perpendiculaires à la direction, et perpendiculaires entre elles.

Dans un premier mode de réalisation, les faces des doigts s'étendent selon des plans parallèles à un plan contenant la troisième direction.

Dans un deuxième mode de réalisation, les faces des doigts sont inclinées par rapport aux deuxième et troisième directions. En d'autres termes, les faces des doigts s'étendent selon des plans ne contenant ni la deuxième, ni la troisième direction.

Les faces des doigts peuvent également s'étendre selon des plans parallèles à un plan contenant la deuxième direction. En d'autres termes, les faces des doigts s'étendent selon des plans ne contenant pas la troisième direction.

Dans un exemple de réalisation, les faces des doigts en regard sont parallèles entre elles.

Les doigts peuvent avoir sensiblement une section rectangulaire ou une section sensiblement trapézoïdale selon un plan parallèle à un plan défini par les première et deuxième directions.

En outre, le premier et le deuxième peignes peuvent comporter un corps principal auquel sont raccordés, par une extrémité, les doigts du premier et du deuxième peignes respectivement, les corps s'étendant alors, par exemple, au moins en partie sensiblement selon un axe parallèle à la première direction de déplacement.

Dans un deuxième exemple de réalisation, le premier peigne comporte un cadre sensiblement rectangulaire comportant des doigts s'étendant en épi vers l'intérieur du cadre et dans lequel le deuxième peigne comporte un bras principal s'étendant selon la première direction, les doigts du deuxième peigne s'étendant en épi du bras principal.

Le deuxième peigne peut comporter également un bras secondaire perpendiculaire au bras principal et s'étendant sensiblement selon la deuxième direction, les doigts du deuxième peigne s'étendant également en épi à partir du bras secondaire.

De manière avantageuse, le dispositif comporte un plan de symétrie contenant la première direction et un plan de symétrie contenant une deuxième direction perpendiculaire à la direction.

De plus, au repos, le deuxième peigne peut être décentré par rapport au premier peigne.

Avantageusement, les peignes ont un déplacement relatif dans la deuxième direction.

En outre, le dispositif selon la présente invention peut comporter des moyens de guidage autorisant le déplacement du deuxième peigne par rapport au premier peigne selon la première direction de déplacement.

Les moyens de guidage peuvent, par exemple, raccorder des extrémités du bras principal du deuxième peigne au cadre du premier peigne.

Dans un exemple de réalisation, le cadre comporte au niveau d'une partie médiane de ses grands côtés, un doigt ayant la forme d'un triangle et le bras secondaire du deuxième peigne comporte à chacune de ses extrémités deux doigts inclinés l'un rapport à l'autre de manière à définir un espace de réception du doigt de forme triangulaire du cadre, en regard.

Dans un exemple de réalisation, les doigts s'étendent selon deux plans de manière à former des chevrons.

Dans une variante de réalisation, le deuxième peigne comporte des doigts s'étendant de part et d'autre du corps principal, les doigts du deuxième peigne étant interdigités avec les doigts des premiers peignes disposés de part et d'autre du corps et des miroirs électrostatiques sont, avantageusement, interposés entre des doigts du premier peigne et des doigts du deuxième peigne de manière à permettre un déplacement du deuxième peigne par rapport au premier peigne selon un sens et son sens opposé.

De manière avantageuse, le premier peigne est fixe et le deuxième peigne est mobile par rapport au premier peigne.

En outre, le premier peigne est, de préférence, isolé électriquement du deuxième peigne, par exemple en utilisant d'un substrat isolant duquel sont solidaires le premier et le deuxième peignes.

BRÈVE DESCRIPTION DES DESSINS

La présente invention sera mieux comprise à l'aide de la description qui va suivre et des dessins en annexes, sur lesquels :

- la figure 1 est une vue schématique de dessus d'un premier exemple d'un dispositif capacitif selon un premier mode de réalisation de l'invention,
- la figure 2 est une vue schématique de dessus d'un dispositif capacitif selon un deuxième exemple du premier mode de réalisation de l'invention,
- la figure 3 est une variante de réalisation du dispositif de la figure 2,
- la figure 4 est une vue schématique de dessus d'un dispositif capacitif selon une deuxième variante du deuxième exemple du premier mode de réalisation de l'invention,
- la figure 5 est une vue en perspective d'un détail d'un deuxième mode de réalisation d'un dispositif selon la présente invention,
- la figure 6 est une variante de réalisation du dispositif de la figure 5,
- la figure 7 est une vue en perspective d'un dispositif incorporant le détail de la figure 5.

EXPOSÉ DÉTAILLÉ DE MODES DE RÉALISATION PARTICULIERS

Sur l'ensemble des figures, les faces des doigts en regard ont été dessinées planes pour en faciliter la compréhension. Mais des surfaces, par exemple concaves/convexes peuvent être envisagées, des formes disparates également.

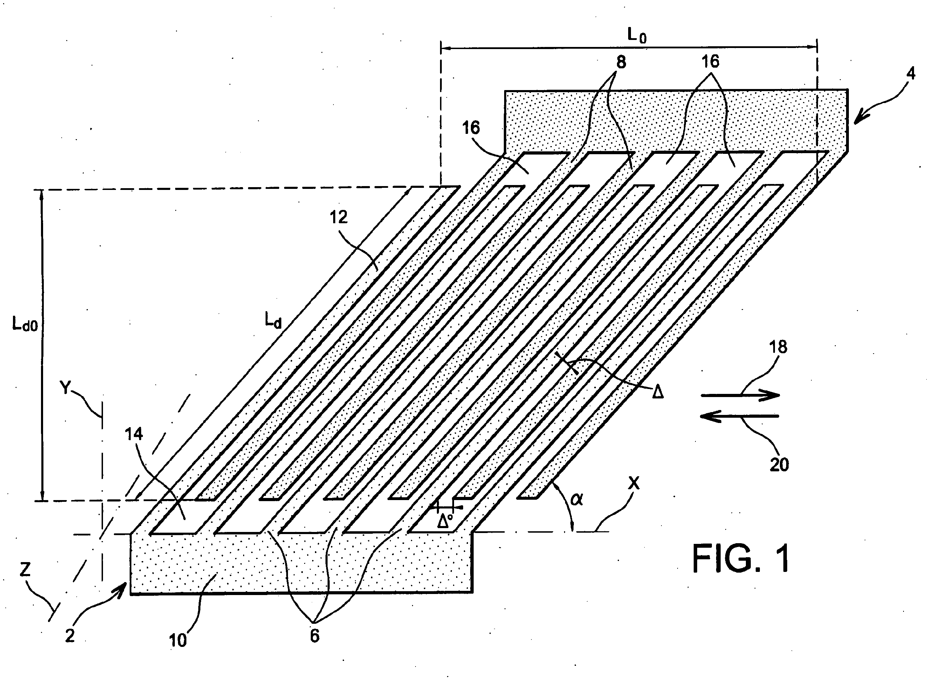

Sur la figure 1, on peut voir un dispositif capacitif selon un premier mode de réalisation, comportant un premier 2 et un deuxième 4 peignes comportant respectivement des doigts 6 et 8.

Nous décrirons en détail le peigne 2, sachant que, dans l'exemple représenté, les deux peignes 2,4 ont sensiblement la même structure.

Le peigne 2 comporte un corps 10 s'étendant sensiblement selon une direction X, auquel les doigts 6 sont fixés par une extrémité.

Le dispositif selon la présente invention s'étend également selon un axe Y orthogonal à l'axe X et contenu dans le plan de la feuille et selon un axe Z orthogonal aux axes X et Y.

Les doigts 6 s'étendent selon des plans contenant l'axe Z et inclinés par rapport à un plan défini par les axes Y et Z. Les doigts sont donc inclinés par rapport à un plan orthogonal à la direction X de déplacement.

Dans l'exemple représenté, les doigts 6 ont une section selon un plan défini par les axes X et Y, en forme d'un parallélogramme non rectangle, comportant des grands côtés 12, avantageusement parallèles entre eux, et définissent des espaces 14 également en forme de parallélogramme non rectangle.

Les dimensions du deuxième peigne sont, dans l'exemple représenté, sensiblement les mêmes que celles du premier peigne 2. Les doigts 8 sont raccordés à un corps 11 sensiblement parallèle au corps 10 et définissent également des espaces 16 en forme de parallélogramme non rectangle.

Les doigts 8 sont disposés dans les espaces 14, et réciproquement les doigts 6 sont disposés dans les espaces 16.

Les premier et deuxième peignes 2, 4 ont un mouvement relatif selon la direction X dans un sens 18 ou 20, les flancs des doigts du premier peigne se rapprochant ou s'éloignant des flancs des doigts du deuxième peigne en regard. Un seul peigne ou les deux peignes peuvent être mobiles.

Les flancs des doigts sont contenus, dans le mode de réalisation représenté, dans un plan incliné par rapport à un plan normal à la direction X. Les flancs forment alors un angle $\alpha$ avec la direction X.

De manière avantageuse, les flancs sont contenus dans des plans parallèles entre eux, mais cette disposition n'est pas limitative.

On peut prévoir des peignes dont les faces en regard ne soient pas parallèles, cependant le distance entre les faces n'étant pas uniforme tout le long de celles-ci, le débattement est limité par la plus petite distance d'entrefer.

Les différentes dimensions du dispositif selon la présente invention peuvent être définies en fonction de l'angle d'inclinaison $\alpha$ des doigts avec les relations suivantes.

$$\Delta = \Delta_0 \sin(\alpha)$$

$$l_d = \frac{l_{d0}}{\sin(\alpha)}$$

$$S = h\,l_d = \frac{h\,l_{d0}}{\sin(\alpha)} = \frac{S_0}{\sin(\alpha)}$$

$$C_{repos} = \frac{2\varepsilon_0 S}{\Delta} = \frac{2\varepsilon_0 S_0}{\Delta_0 \sin^2(\alpha)} = \frac{C_0}{\sin^2(\alpha)}$$

$$Q = Q_0 \Rightarrow F_e = \frac{Q_0^2}{2\varepsilon_0 \Delta_0 S_0} z \sin(\alpha) = F_{e0} \sin(\alpha)$$

$$V_{max} = V_{max\,0} \Rightarrow F_e = \frac{V_{max\,0}^2 C_{repos}^2}{2\varepsilon_0 \Delta_0 S_0} z \sin(\alpha) = \frac{F_{e0}}{\sin^3(\alpha)}$$

$$F_e = F_{e0} \Rightarrow V_{max} = V_{max\,0} \sin^{\frac{3}{2}}(\alpha)$$

- h étant l'épaisseur de la structure ;
- $l_d$ étant la longueur des doigts ;
- S étant la surface capacitive latérale d'un doigt ;
- $\Delta$ étant l'épaisseur d'entrefer séparant deux doigts interdigités au repos ;
- Q étant la charge stockée sur un doigt ;
- Fe étant la force électrostatique exercée par un doigt selon X ;
- $C_{repos}$ étant la valeur de la capacité vue par un doigt en position de repos (doigts équidistants des deux doigts voisins) ;
- a étant l'angle formé par la surface capacitive des doigts avec la direction du déplacement X, les paramètres indexés « 0 » correspondent au cas standard des peignes non inclinés ($\alpha_0 = 90°$).

Ainsi, dans le cas où l'angle $\alpha$ est égal à 45°,

$$\alpha = 45° \Rightarrow \begin{vmatrix} \Delta = \frac{\Delta_0}{\sqrt{2}} \\ l_d = \sqrt{2}\, l_{d0} \\ S = \sqrt{2}\, S_0 \\ C_{repos} = 2\, C_0 \\ Q = Q_0 \Rightarrow F_e = \frac{F_{e0}}{\sqrt{2}} \\ V_{max} = V_{max\,0} \Rightarrow F_e = 2\sqrt{2}\, F_{e0} \\ E_{max} = E_{max\,0} \Rightarrow F_e = F_{e0} \\ F_e = F_{e0} \Rightarrow V_{max} = \frac{V_{max\,0}}{\sqrt{2\sqrt{2}}} \end{vmatrix}$$

Pour un dispositif capacitif de type classique, pour lequel $\alpha$ est égal à 90°, on obtient:

$$\alpha_0 = 90° \Rightarrow \begin{vmatrix} l_d = l_{d0} \\ S = S_0 \\ \Delta = \Delta_0 \\ Q = Q_0 \\ F_e = F_{e0} \\ C_{repos} = C_0 \end{vmatrix}$$

Le choix de l'angle s'effectue sur la base d'un compromis entre le gain sur la capacité et les contraintes mécaniques et l'encombrement. $\alpha$ est par exemple compris entre 30° et 60°.

Pour un dispositif selon la présente invention, il apparaît alors que l'entrefer $\Delta$ est plus faible que dans un dispositif à dents perpendiculaires à la direction de déplacement. La tension sous laquelle on retire la charge pour obtenir une force électrostatique équivalente à celle obtenue avec un dispositif classique, est réduite d'un facteur $\sin^{3/2}(\alpha)$.

Par ailleurs, la capacité au repos est augmentée d'un facteur $1/\sin^2(\alpha)$, ce qui permet de réduire l'effet des capacités parasites.

Par conséquent, un dispositif selon la présente invention présente un même encombrement spatial qu'un dispositif selon l'état de la technique et offre une capacité au repos augmentée et une force électrostatique augmentée pour une tension maximale donnée.

Dans l'exemple représenté, les doigts d'un même peigne sont équidistants, mais on peut prévoir des distances différentes entre chaque doigt d'un même peigne.

Sur la figure 1, seuls deux peignes sont représentés pour des raisons de clarté, mais le dispositif peut comporter plus de deux peignes.

Dans le cas d'un dispositif destiné à engendrer un déplacement entre les peignes 2,4, ceux-ci sont raccordés électriquement à une source de tension (non représenté) apte à appliquer une différence de tension entre les peignes, en particulier entre une face d'un doigt d'un peigne et une face en regard d'un doigt de l'autre peigne, générant une force électrostatique entre les deux faces en regard. L'alimentation électrique est gérée par exemple par une unité électronique.

Dans le cas d'un dispositif de conversion d'un mouvement mécanique entre les deux peignes en une énergie électrique, les peignes sont raccordés à une unité électronique apte à convertir une variation de capacité en une énergie électrique. Dans le cas d'un dispositif de mesure d'accélération, les peignes sont raccordés à un circuit électronique qui permet de mesurer la variation de capacité et par là, l'accélération.

Les peignes 2 et 4 sont avantageusement électriquement isolés l'un de l'autre afin d'éviter tout court-circuit en cas de contact entre eux.

Une isolation électrique entre les peignes mobiles par rapport aux peignes fixes peut être obtenue par assemblage sur un isolant.

5

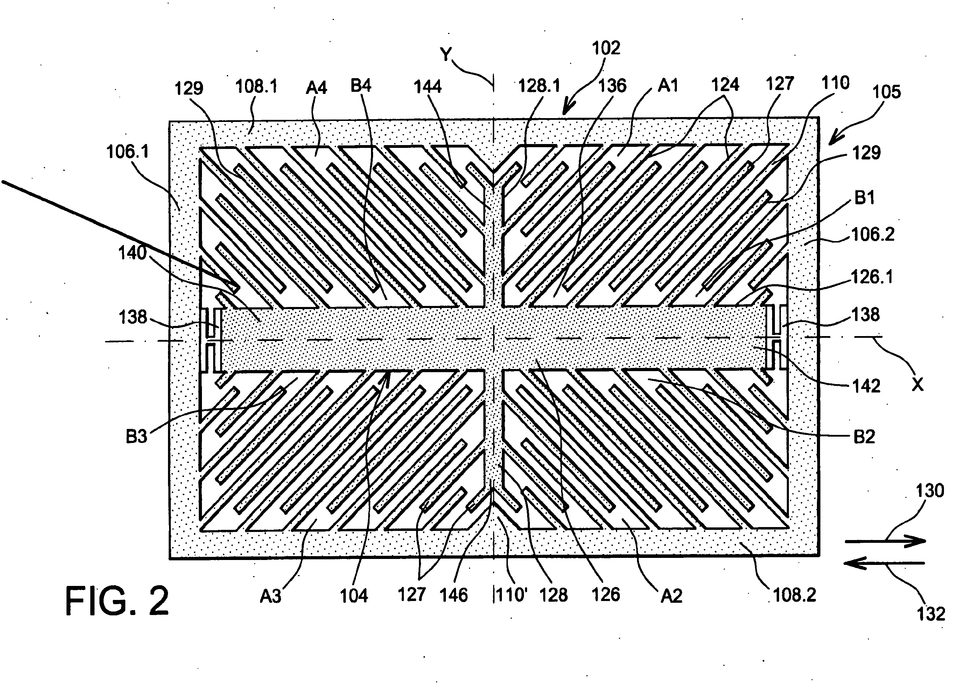

Sur la figure 2, on peut voir un deuxième exemple de réalisation d'un dispositif selon le premier mode de réalisation de la présente invention, dans lequel l'inclinaison des flancs des doigts peut varier d'un doigt à l'autre.

Le dispositif de la figure 2 comporte un premier peigne fixe 102 et un deuxième peigne mobile 104 disposé à l'intérieur du premier peigne.

Le premier peigne 102 comporte un cadre 105 de forme sensiblement rectangulaire formé de deux petits côtés 106.1, 106.2 et de deux grands côtés 108.1, 108.2.

Le premier peigne comporte des doigts 110 distribués selon quatre zones A1, A2, A3, A4.

Les zones A1 à A4 sont délimitées par les petits 106.1, 106.2, les grands 108.1, 108.2 côtés, et les axes X et Y, et forment quatre rectangles de mêmes dimensions.

Dans chaque zone A1 à A4, les doigts 110 s'étendent selon une direction particulière.

Nous décrirons la zone A1, les zones A2 à A4 étant, dans l'exemple représenté, de structure équivalente.

Les doigts 110 s'étendent des petit et grand côtés vers l'intérieur du cadre 105, selon une disposition en épi.

Les doigts 110 comportent des flancs 1.24, dans l'exemple représenté parallèles entre eux et sont inclinés suivant un angle $\alpha$ par rapport à l'axe X.

Les flancs 124 délimitent des espaces recevant des doigts 127 du deuxième peigne 104.

Les doigts 110 de la zone A3 ont la même orientation que celle des doigts 110 de la zone A1.

Dans l'exemple représenté, les doigts 110 des zones A2 et A4 sont inclinés d'un angle 180°-$\alpha$ dans le sens trigonométrique. Ainsi les zones A1 et A4 sont symétriques par rapport à un plan passant par l'axe Y et orthogonal au plan de la feuille, ainsi que les zones A2 et A3.

Le deuxième peigne 104 a sensiblement la forme d'une croix, comportant une branche principale 126 disposée selon axe X et une branche secondaire 128 d'axe Y, sensiblement perpendiculaire à la branche principale 126.

Le deuxième peigne 104 est mobile selon l'axe X dans un sens 130 et 132.

Les branches 126,128 du deuxième peigne 104 délimitent quatre zones B1 à B4 recouvrant les zones A1 à A4 respectivement et dans lesquelles les doigts 127 ont une disposition particulière adaptée à la disposition des doigts 110 dans les zones A1 à A4 respectivement.

Nous décrirons la zone B1, les zones B2 à B4 étant de structure équivalente.

Les doigts 127 s'étendent en épi des demi branches 126.1 et 128.1 vers l'extérieur de la croix. Les flancs 129 des doigts 127 sont inclinés selon un angle $\alpha$ par rapport à l'axe X et délimitent des espaces 136 pour recevoir les doigts 110 de la zone A1.

Ainsi, dans l'exemple représenté, les flancs 129 des doigts 127 sont parallèles aux flancs 124 des doigts 110.

Dans l'exemple représenté, tous les flancs 124 et 129 d'une même zone étant parallèles entre eux, on parle indifféremment de l'inclinaison des doigts ou des flancs.

D'autre part, dans le cas particulier représenté à la figure 2, les doigts des zones A1 et A4, et des zones A2 et A3 sont parallèles entre eux. Mais les cas d'orientations différentes pour les doigts de chaque zone A1 à A4 associées aux zones B1 à B4 respectivement, ne sortent pas du cadre de la présente invention.

Dans l'exemple représenté, $\alpha$ est égal à 45°.

Le dispositif selon la figure 2 comporte également des moyens de guidage 138 du déplacement du deuxième peigne 104 par rapport au premier peigne 102.

Ces moyens 138 raccordent avantageusement des extrémités 140,142 de la branche principale 126 aux plus petits côtés 106.1, 106.2 en regard.

Ces moyens sont soit isolants électriquement, soit fixés à un support isolant afin d'isoler électriquement les peignes 102 et 104.

Les moyens 138 sont, par exemple formés part des balanciers, des ressorts.

Le deuxième peigne 104 peut par exemple être mis en mouvement par rapport au premier peigne 102 par un système d'entraînement mécanique, ou par des vibrations mécaniques appliquées à un élément externe, les vibrations peuvent alors être appliquées au peigne 104 par l'intermédiaire de liaisons mécaniques souples reliant le peigne 104 à l'élément externe. Ces moyens de type ressort peuvent être réalisés en silicium sous forme de poutres gravées, ou en métal ou en matériau élastique (ressort, caoutchouc). Ces moyens peuvent également avoir une fonction de guidage de déplacement des peignes l'un par rapport à l'autre.

Ce dispositif peut par exemple permettre de convertir une énergie générée par un mouvement mécanique en énergie électrique par procédé électrostatique.

Il est, par ailleurs, possible d'utiliser ce dispositif en tant qu'actionneur mécanique en appliquant une différence de potentiel entre les deux peignes.

Il est à noter que, si en position repos, le deuxième peigne 104 est centré par rapport au premier peigne 102, la force électrostatique est nulle en position centrale du fait de la symétrie du dispositif, il n'est alors pas possible de déplacer le peigne 104 par rapport au peigne 102. Afin de permettre une mise en mouvement du peigne 104, on peut prévoir de modifier la position relative des peignes 102 et 104 au repos, par exemple en décalant le peigne 104 par rapport au peigne 102 en position repos, de manière à ce que le dispositif ne soit pas symétrique au repos.

Dans l'exemple représenté, les doigts 127 disposés aux extrémités 144,146 de la branche secondaire 126 de part et d'autre de la branche, sont perpendiculaires entre eux et forment un espace sensiblement triangulaire, recevant un doigt 110' disposée dans la partie médiane d'un grand côté 108.1,108.2, avantageusement de forme sensiblement triangulaire.

Les doigts du deuxième peigne 104 sont répartis de manière symétrique par rapport à la branche secondaire 128, ce qui permet de répartir de manière symétrique les masses et les forces électrostatiques appliquées au peigne 104.

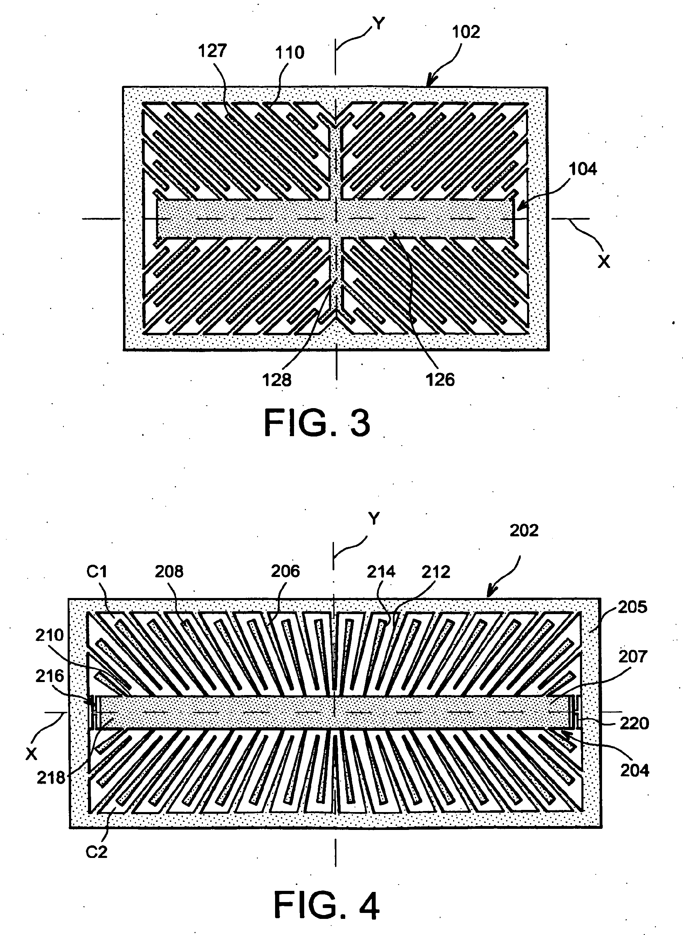

Sur la figure 3, on peut voir une variante de réalisation du dispositif représenté en figure 2, dans laquelle le deuxième peigne 104 peut se déplacer selon plusieurs directions, avantageusement selon les axes X et Y.

Le deuxième peigne 104 est alors suspendu par rapport au premier peigne 102 par des moyens non représentés.

Ceci est particulièrement intéressant lorsque l'on souhaite récupérer l'énergie de vibration dans un milieu complexe comportant plusieurs sources de vibration de directions différentes et/ou une source de direction aléatoire.

Le comportement capacitif du dispositif lors d'un déplacement selon l'axe Y est sensiblement identique au comportement capacitif lors d'un déplacement selon l'axe X. Les comportements dans les deux directions X et Y sont d'autant plus proches que l'angle des doigts par rapport à l'axe X est proche, en valeur absolue, de 45°. Ce dispositif est donc avantageusement adapté à une utilisation dans un environnement quelconque.

Dans le cas, où l'on prévoit une amplitude du déplacement relatif plus importante selon une direction, il est alors possible d'optimiser le dispositif en choisissant un angle d'inclinaison des doigts adapté à la direction de plus forte amplitude de vibration, par exemple on choisira un angle d'autant plus faible par rapport à l'axe X, que l'amplitude de déplacement selon X est importante par rapport à l'amplitude selon Y.

Sur la figure 4, on peut voir une autre variante d'un dispositif selon le premier mode de réalisation, dans lequel l'inclinaison des doigts varie de manière progressive sur toute l'étendue du dispositif, ce qui permet d'occuper pleinement le dispositif.

Comme pour les dispositifs des figures 2 et 3, le dispositif selon la figure 4 comporte un premier peigne 202 formant cadre et un deuxième peigne 204 disposé à l'intérieur du premier peigne 202.

Dans l'exemple représenté, le premier peigne 202 comporte un cadre rectangulaire 205.

Le premier peigne peut avoir tout autre forme adaptée à un environnement spécifique et à un volume disponible, par exemple il peut être circulaire, elliptique, en chevron ou avoir toute autre forme.

De plus, le premier peigne n'a pas nécessairement la forme d'un cadre 205 fermé.

Le deuxième peigne 204 est formé par une branche unique 207 d'axe X.

Le premier 202 et le deuxième 204 peignes comportent respectivement des doigts 206, 208 interdigités.

Le premier peigne 202 comporte une première zone C1 et une deuxième zone C2, dans l'exemple représenté, symétriques par rapport à l'axe X

Dans la zone C1, les doigts 206 s'étendent d'une paroi intérieure du cadre 205 en direction de l'intérieur du cadre. Les doigts 206 sont inclinés par rapport à l'axe X d'un angle $\alpha$. Dans le mode de réalisation représenté, l'angle d'inclinaison $\alpha$ des doigts augmente entre 0° et 180° en considérant le sens trigonométrique.

Sur la figure 4, on peut voir que les doigts 206 sont disposés de manière symétrique par rapport à un plan orthogonal à la feuille et contenant l'axe Y. Mais ceci n'est pas limitatif et on peut prévoir une distribution différente sans plan de symétrie.

Le peigne 204 est également symétrique par rapport à un plan orthogonal à la feuille et passant par l'axe X.

Les doigts du peigne 204 s'étendent d'un côté 210 de la branche 207 dans la zone C1 du premier peigne et sont distribués sur toute la longueur du côté 210 avec un angle d'inclinaison variant de manière croissante, entre 0° et au plus 180° en considérant le sens trigonométrique.

La distribution des doigts 208 est telle que les doigts 208 s'interposent entre les doigts 206 du premier peigne 202.

De manière avantageuse, les flancs 212,214 des doigts 206,208 respectivement en regard sont parallèles, autorisant un déplacement relatif identique selon la direction du déplacement.

Les doigts ont alors sensiblement, vus de dessus, un profil trapézoïdal de manière à assurer le parallélisme des flancs.

La distribution des doigts 206 et 208 dans la zone C2 est symétrique, comme décrit précédemment.

Le dispositif comporte également des moyens de guidage 216 du déplacement du deuxième peigne 204 par rapport au premier peigne 202. Ces moyens 216 raccordent avantageusement des extrémités 218,220 de la branche 207 aux plus petits côtés du cadre 205.

Dans l'exemple représenté le mouvement relatif des deux peignes 202,204 s'effectue selon l'axe X, mais on peut prévoir comme pour le dispositif de la figure 3, un mouvement relatif selon plusieurs directions, notamment selon les axes X et Y.

Comme décrit précédemment, la disposition symétrique des doigts n'est en aucun cas limitative, et toute distribution inclinée des doigts permettant une amplitude suffisante entre les peignes peut convenir.

En outre, la disposition des moyens de guidage peut être différente et raccorder, par exemple, le deuxième peigne au grand côté du premier peigne.

Dans ce mode de réalisation, les doigts bénéficiant au mieux des avantages de la présente invention sont ceux qui sont les plus inclinés par rapport au plan orthogonal au déplacement, c'est-à-dire au plan orthogonal à l'axe X.

Il est alors possible en inclinant les doigts, d'optimiser le nombre de doigts pour un volume donné.

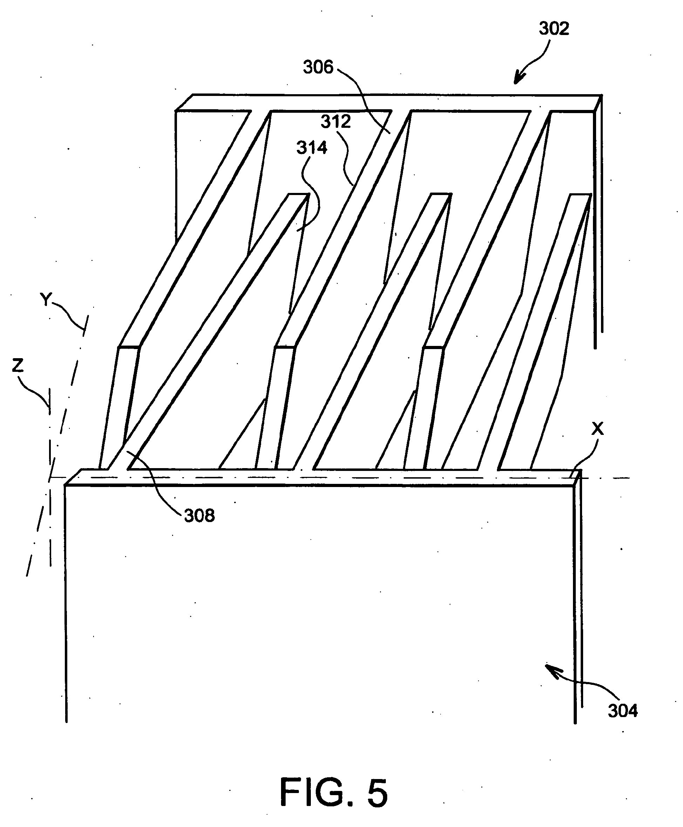

La figure 5 est une vue en perspective d'un deuxième mode particulier de réalisation d'un dispositif selon la présente invention.

Le dispositif selon la figure 5 comporte un premier peigne 302 et un deuxième 304 comportant respectivement des doigts 306,308 interdigités.

Les peignes sont aptes à avoir un mouvement relatif selon un première direction X et une deuxième direction Y, perpendiculaires entre elles et contenus dans le plan de la feuille. Les peignes s'étendent également selon une direction Z perpendiculaire à X et Y.

Les doigts sont, dans l'exemple représenté, sensiblement plans et s'étendent selon un plan à la fois inclinés par rapport à un plan défini par les directions Y et Z et à la direction Z.

Des doigts contenus dans des plans parallèles au plan YZ et inclinés par rapport à la direction Z, ne sortent pas du cadre de la présente invention.

Dans l'exemple représentés, les doigts 306,308 comportent des flans 312,314 respectivement en regard, parallèles entre eux.

On peut prévoir également des flans 312,314 non parallèles.

Les peignes 302,304 peuvent avoir un mouvement relatif selon l'axe X et/ou Y.

Une telle disposition des doigts peut également s'appliquer aux dispositifs des figures 2 à 3.

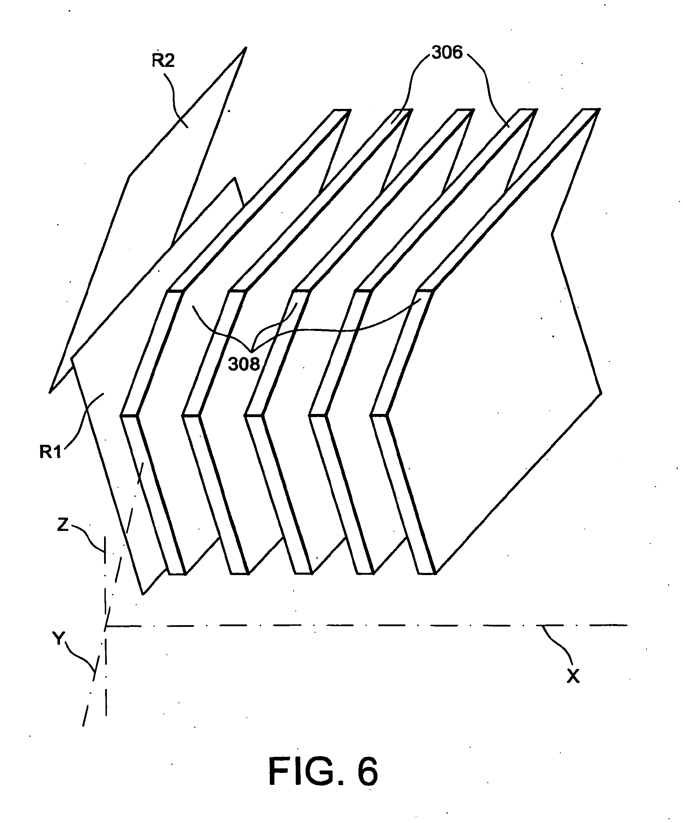

Sur la figure 6, on peut voir une variante du dispositif de la figure 5, dans lequel les doigts 306,308 ne s'étendent plus dans un plan unique mais dans deux.plans sécants, parallèles à des plans R1, R2, chaque plan R1, R2 étant incliné par rapport au plan défini par Y et Z, et par rapport à Z.

Dans l'exemple représenté, les plans R1 et R2 sont disposés de manière à former un chevron. Ainsi les doigts présentent un plan de symétrie parallèle à un plan défini par les axes X et Y.

Ce mode particulier de réalisation permet avantageusement d'augmenter la tenue des doigts aux efforts impliquées par les forces électrostatiques et l'inertie propre des doigts, tout en optimisant le volume capacitif.

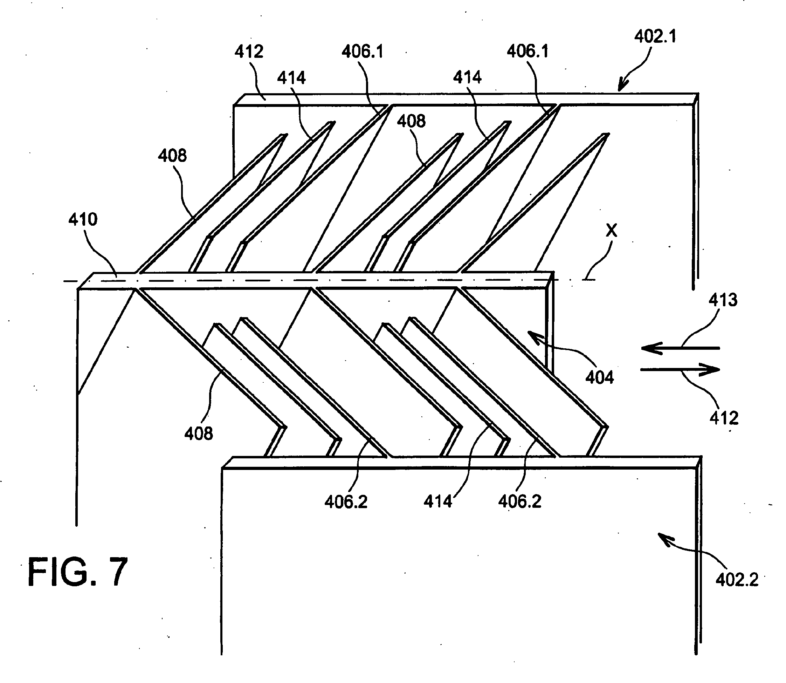

Sur la figure 7, on peut voir un dispositif incorporant la forme particulière des peignes de la figure 5

Le dispositif comporte un peigne mobile 404 et un premier et un deuxième peignes fixes 402.1, 402.2.

Le peigne 404 comporte un corps central 410 s'étendant selon un axe X et des doigts 408 disposés de part et d'autre du corps 410 selon la disposition de la figure 5, en forme de sapin.

Les peignes 402.1 et 402.2 sont sensiblement identiques, nous décrirons le peigne 402.1.

Le peigne 402.1 comporte un corps 412 s'étendant longitudinalement selon un axe parallèle à l'axe X et des doigts 406.1 disposés comme sur la figure 5 et venant s'interposer entre des doigts 408 en saillie d'un côté du corps 410.

Les doigts 406.2 du peigne 402.2 sont disposés de la même manière de l'autre côté du corps 410.

De manière avantageuse, le dispositif comporte également des miroirs électrostatiques 414 interposés entre chaque paire formée par un doigt 408 et un doigt 406.1 d'un côté du corps 410 et un doigt 408 et un doigt 406.2 de l'autre côté du corps 410, dans un sens indiqué par la flèche 412.

Un miroir électrostatique 414 permet de limiter, voire d'annuler la force électrostatique qui s'applique entre les deux doigts qu'il sépare. Ainsi, si on met les miroirs 414 au potentiel du peigne 404, il n'y a plus de force appliquée du coté des doigts du peigne 404 se trouvant en face d'un miroir électrostatique 414. La dissymétrie du dispositif permet de générer un effort mécanique dans un sens 412 ou dans un sens 413 opposé au sens 412.

Les miroirs électrostatiques 414 sont également reliés à une source électrique qui peut être la même que celle des peignes 402,404 ou une source indépendante.

Nous allons maintenant expliquer le fonctionnement d'un tel dispositif :

- lorsqu'une différence de tension électrique est appliquée entre les peignes 402.1 et 404, une force électrostatique s'applique au peigne 404 dans les sens 413,
- lorsqu'une différence de tension électrique est appliquée entre les peignes 402.2 et 404, une force électrostatique s'applique au peigne 404 dans le sens 412.

Le dispositif selon la figure 7, permet avantageusement de créer une force mécanique dans un sens 412 ou dans un sens opposé 413 quelle que soit la position alors que pour les dispositifs représentés aux figures 1 à 5, la force électrostatique, pour une position donnée, ne s'applique que dans un sens.

Les miroirs électrostatiques peuvent également s'interposer entre une paire de doigts 408 et 406.1 ou 406.2 dans le sens 413.

Le peigne 402.1 et/ou le peigne 402.2 peuvent également être mobiles. On peut également prévoir un peigne 404 fixe et des peignes 402.1, 402.2 mobiles.

Il est également envisageable de prévoir des doigts s'étendant selon des plans non parallèles entre eux, les dispositions particulières des doigts des dispositifs des figures 2 et 3 étant également applicables.

Des dispositifs des figures 2 et 3 comportant des miroirs électrostatiques ne sortent pas du cadre de la présente invention.

Les faces des doigts en regard ne sont pas nécessairement planaires ; les formes correspondantes des faces en regard peuvent être par exemple ondulées ou en dent de scie,

On a bien réalisé un dispositif capacitif à volume capacitif optimisé, puisque l'inclinaison des doigts permet d'augmenter la force mécanique exercée sur le peigne mobile pour une tension appliquée et un volume donnés.

Le dispositif selon la présente invention peut être réalisé par exemple par usinage dans un matériau massif conducteur ou comportant un revêtement métallique, le matériau peut être du tungstène, du silicium dopé, un plastique ou une céramique métallisé.

Les moyens de rappel du dispositif en position repos, type ressort de rappel sous forme de poutre souple, peuvent également être directement réalisés par usinage dans le matériau massif

La fabrication de ce dispositif peut également être réalisée par les technologies classiques de la microélectronique, par exemple par gravure profonde (DRIE), collage sur isolant (verre).

Les procédés actuellement utilisés pour fabriquer des accéléromètres électrostatiques sont également applicables.

Il est également envisageable de réaliser ces dispositifs par moulage et/ou collage.

Les dispositifs selon la présente invention peuvent être utilisés dans des accéléromètres, gyromètres et sismomètres et dans tout dispositif utilisant la variation de capacité par variation d'entrefer.

## Revendications

**1.** Dispositif capacitif comportant au moins un premier (2, 102, 202, 302, 402 . 1, 402 .2) et un deuxième (4, 104, 204, 304, 404) peignes, munis de doigts, les doigts du premier et du deuxième peigne étant interdigités, lesdits peignes étant aptes à être mobiles l'un par rapport à l'autre selon au moins une première direction déterminée (X) selon un rapprochement-éloignement des axes des doigts, au moins un doigt du premier peigne (2,102,202,302,402.1,402.2) comportant une face en regard d'une face d'un doigt du deuxième peigne (4,104,204,304,404) **caractérisé en ce que** l'axe du doigt du premier peigne et l'axe du doigt du deuxième peigne sont inclinés par rapport à un plan orthogonal à la première direction (X) de déplacement des peignes, le plan étant défini par des deuxième (Y) et troisième (Z) directions perpendiculaires à la première direction (X), et perpendiculaires entre elles.

**2.** Dispositif selon la' revendication 1, dans lequel les faces des doigts (6, 8, 108, 106, 208, 206) s'étendent selon des plans parallèles à un plan contenant la troisième direction (Z).

**3.** Dispositif, selon la revendication 1, dans lequel les faces des doigts s'étendent selon des plans parallèles à un plan contenant la deuxième direction (Y).

**4.** Dispositif selon la revendication 1, dans lequel les faces des doigts sont inclinées par rapport aux deuxième et troisième directions (Y, Z).

**5.** Dispositif selon l'une des revendications 1 à 4, dans lequel les faces des doigts en regard sont parallèles entre elles.

**6.** Dispositif selon l'une quelconque des revendications 1 à 5, dans lequel les doigts ont sensiblement une section rectangulaire selon un plan parallèle à un plan défini par les première (X) et deuxième (Y) directions.

**7.** Dispositif selon l'une quelconque des revendications 1 à 5, dans lequel les doigts (206,208) ont sensiblement une section trapézoïdale selon un plan parallèle à un plan défini par les première (X) et deuxième (Y) directions.

**8.** Dispositif selon l'une quelconque des revendications 1 à 7, dans lequel le premier (2) et le deuxième (4) peignes comportent un corps principal (10,11) auquel sont raccordés par une extrémité les doigts (6,8) du premier (2) et du deuxième (4) peignes respectivement.

**9.** Dispositif selon la revendication précédente, dans lequel les corps (10,11) s'étendent au moins en partie sensiblement selon un axe parallèle à la première direction (X) de déplacement.

**10.** Dispositif selon l'une quelconque des revendications 1 à 9, dans lequel le premier peigne (102,202) comporte un cadre (105,205) sensiblement rectangulaire comportant des doigts (106,206) s'étendant en épi vers l'intérieur du cadre et dans lequel le deuxième peigne (104,204) comporte un bras principal (126,207) s'étendant selon la première direction (X), les doigts (108,208) du deuxième peigne (104,204) s'étendant en épi du bras principal.

11. Dispositif selon la revendication précédente, dans lequel le deuxième peigne (104) comporte également un bras secondaire (128) perpendiculaire au bras principal (126) et s'étendant sensiblement selon la deuxième direction (Y), les doigts (108) du deuxième peigne (104) s'étendant également en épi à partir du bras secondaire (128).

12. Dispositif selon la revendication précédente, comportant un plan de symétrie contenant la première direction (X) et un plan de symétrie contenant une deuxième direction (Y) perpendiculaire à la première direction (X).

13. Dispositif selon l'une quelconque des revendications précédentes, dans lequel au repos le deuxième peigne est décentré par rapport au premier peigne.

14. Dispositif selon l'une quelconque des revendications précédentes, dans lequel les peignes (102,104) ont un déplacement relatif dans la deuxième direction (Y).

15. Dispositif selon l'une quelconque des revendications 1 à 13, comportant des moyens de guidage (138,206)) autorisant.le déplacement du deuxième peigne (104,204) par rapport au premier peigne (102,202) selon la première direction (X) de déplacement.

16. Dispositif selon la revendication précédente en combinaison avec la revendication 10, 11 ou 12, dans lequel les moyens de guidage (138,216) raccordent des extrémités du bras principal (126,207) du deuxième peigne (104,204) au cadre (105,205) du premier peigne (102,202).

17. Dispositif selon la revendication 10,11 ou 12, dans lequel le cadre (105) comporte au niveau d'une partie médiane de ses grands côtés, un doigt (110') ayant la forme d'un triangle, et dans lequel le bras secondaire (128) du deuxième peigne (104) comporte à chacune de ses extrémités deux doigts inclinés l'un par rapport à l'autre de manière à définir un espace de réception du doigt de forme triangulaire (110') du cadre (105), en regard.

18. Dispositif selon l'une quelconque des revendications précédentes, dans lequel les doigts (306,308) s'étendent selon deux plans (R1, R2) de manière à former des chevrons.

19. Dispositif selon l'une quelconque des revendications précédentes, dans lequel le deuxième peigne (404) comporte des doigts (408) s'étendant de part et d'autre du corps principal (410), les doigts du deuxième peigne étant interdigités avec les doigts (406.1,406.2) des premiers peignes (402.1,402.2), disposés de part et d'autre du corps (410).

20. Dispositif selon la revendication précédente, comportant des miroirs (414) électrostatiques interposés entre les doigts (406.1, 406.2) du premier peigne (402.1, 402.2) et des doigts (408) du deuxième peigne (404) de manière à permettre un déplacement du deuxième peigne par rapport au premier peigne selon un sens (412) et son sens opposé (413).

21. Dispositif selon l'une quelconque des revendications précédentes, dans lequel le premier peigne est fixe et le deuxième peigne est mobile par rapport au premier peigne.

22. Dispositif selon l'une quelconque des revendications précédentes, dans lequel le premier peigne est isolé électriquement du deuxième peigne.

23. Dispositif selon la revendication précédente, dans lequel les premier et deuxième peignes sont solidaires d'un substrat isolant.


**Claims**

1. Capacitive device comprising at least a first (2, 102, 202, 302, 402.1, 402.2) and a second (4,104,204,304,404) comb, equipped respectively with fingers, the fingers of the first and second comb being interdigital, said combs able to be mobile in relation to one another according to at least one first determined direction (X) depending on the closing-spacing apart of the axes of the fingers, at least one finger of the first comb (2,102,202,302,402.1,402.2) including a face opposite a face of a finger of the second comb (4, 104, 204, 304, 404) **characterised in that** the axis of the finger of the first comb and the axis of the finger of the second comb are inclined relative to a plane orthogonal to the first direction (X) of displacement of the combs, the plane being defined by second (Y) and third (Z) directions perpendicular to the first direction (X), and perpendicular between themselves.

2.  Device according to claim 1, wherein the faces of fingers (6, 8, 108, 106, 208, 206) extend according to planes parallel to a plane containing the third direction (Z).

3.  Device, according to claim 1, wherein the faces of the fingers extend according to planes parallel to a plane containing the second direction (Y).

4.  Device according to claim 1, wherein the faces of the fingers are inclined relative to the second and third directions (Y, Z).

5.  Device according to any of claims 1 to 4, wherein the faces of the fingers opposite are parallel to each other.

6.  Device as according to any of claims 1 to 5, wherein the fingers have a substantially rectangular section according to a plane parallel to a plane defined by first (X) and second (Y) directions.

7.  Device as according to any of claims 1 to 5, wherein the fingers (206, 208) have a substantially trapezoidal section according to a plane parallel to a plane defined by first (X) and second (Y) directions.

8.  Device as according to any of claims 1 to 7, wherein each of the first (2) and second (4) combs comprises a main body (10,11) to which are connected by one end the fingers (6,8) of the first (2) and of the second (4) combs respectively.

9.  Device according to the preceding claim, wherein the bodies (10,11) extend at least in part substantially according to an axis parallel to the first direction (X) of displacement.

10. Device as according to any of claims 1 to 9, wherein the first comb (102,202) comprises a substantially rectangular frame (105,205) comprising fingers (106,206) extending at an angle towards the interior of the frame and wherein the second comb (104,204) comprises a main arm (126, 207) extending according to the first direction (X), the fingers (108,208) of the second comb (104,204) extending at an angle from the main arm.

11. Device according to the preceding claim, wherein the second comb (104) also comprises a secondary arm (128) perpendicular to main arm (126) and extending substantially according to the second direction (Y), the fingers (108) of the second comb (104) extending also at an angle from secondary arm (128).

12. Device according to the preceding claim, comprising a plane of symmetry containing the first direction (X) and a plane of symmetry containing a second direction (Y) perpendicular to the first direction (X).

13. Device as according to any preceding claim, wherein at rest the second comb is decentred in relation to the first comb.

14. Device as according to any preceding claim, wherein combs (102,104) have a relative displacement in the second direction (Y).

15. Device as according to any of claims 1 to 13, comprising guiding means (138, 206)) authorising the displacement of the second comb (104,204) in relation to the first comb (102,202) according to the first direction (X) of displacement.

16. Device according to the preceding claim in combination with claim 10, 11 or 12, wherein guiding means (138,216) connect ends of the main arm (126,207) of the second comb (104,204) to the frame (105,205) of the first comb (102,202).

17. Device according to claim 10,11 or 12, wherein the frame (105) comprises on the central portion of the large sides therein, a finger (110') having the form of a triangle, and wherein the secondary arm (128) of the second comb (104) comprises at each end therein two fingers inclined in relation to each other so as to define a space to receive the finger of triangular form (110') of the frame (105), opposite.

**18.** Device as according to any preceding claim, wherein fingers (306,308) extend according to two planes (R1, R2) so as to form chevrons.

**19.** Device as according to any preceding claim, wherein the second comb (404) comprises fingers (408) extending from both sides of the main body (410), the fingers of the second comb being interdigital with fingers (406.1,406.2) of the first combs (402.1,402.2), arranged on both sides of the body (410).

**20.** Device according to the preceding claim, comprising electrostatic mirrors (414) disposed between fingers (406.1, 406.2) of the first comb (402.1, 402.2) and fingers (408) of the second comb (404) so as to allow for a displacement of the second comb in relation to the first comb according to a direction (412) and the opposite direction thereof (413).

**21.** Device as according to any preceding claim, wherein the first comb is fixed and the second comb is mobile relative to the first comb.

**22.** Device as according to any preceding claim, wherein the first comb is electrically insulated from the second comb.

**23.** Device as according to the preceding claim, wherein the first and second combs are assembled with an insulator substrate.

**Patentansprüche**

**1.** Kapazitives Element, das wenigstens eine erste (2, 102, 202, 302, 402.1, 402.2) und eine zweiten (4, 104, 204, 304, 404), mit Fingern versehene Kammstruktur umfasst, wobei die Finger der ersten und zweiten Kammstruktur ineinandergreifen, die Kammstrukturen bezüglich einander in wenigstens einer ersten bestimmten Richtung (X) in Abhängigkeit von der Annäherung-Entfernung der Fingerachsen dazu befähigt sind, beweglich zu sein, und wenigstens ein Finger der ersten Kammstruktur (2, 102, 202, 302, 402.1, 402.2) eine Fläche gegenüber einer Fläche eines Fingers der zweiten Kammstruktur (4, 104, 204, 304, 404) umfasst, **dadurch gekennzeichnet, dass** die Fingerachse der ersten Kammstruktur und die Fingerachse der zweiten Kammstruktur bezüglich einer Ebene geneigt sind, die zur ersten Verschiebungsrichtung (X) der Kammstrukturen orthogonal ist, wobei die Ebene durch zweite (Y) und dritte (Z) Richtungen definiert wird, die zur ersten Richtung (X) senkrecht sind und untereinander senkrecht sind.

**2.** Element gemäß Anspruch 1, bei dem sich die Flächen der Finger (6, 8, 108, 106, 208, 206) in Ebenen erstrecken, die zu einer die dritte Richtung (Z) enthaltenden Ebenen parallel sind.

**3.** Element gemäß Anspruch 1, bei dem sich die Flächen der Finger in Ebenen erstrecken, die zu einer die zweiten Richtung (Y) enthaltenden Ebenen parallel sind.

**4.** Element gemäß Anspruch 1, bei dem die Flächen der Finger bezüglich der zweiten und dritten Richtung (Y, Z) geneigt sind.

**5.** Element gemäß einem der Ansprüche 1 bis 4, bei dem die Flächen gegenüberliegender Finger untereinander parallel sind.

**6.** Element gemäß einem der Ansprüche 1 bis 5, bei dem die Finger im Wesentlichen einen rechteckigen Querschnitt in einer Ebene aufweisen, die zu einer durch die erste (X) und zweite Richtung (Y) definierten Ebene parallel ist.

**7.** Element gemäß einem der Ansprüche 1 bis 5, bei dem die Finger (206, 208) im Wesentlichen einen trapezförmigen Querschnitt in einer Ebene aufweisen, die zu einer durch die erste (X) und zweite (Y) Richtung definierten Ebene parallel ist.

**8.** Element gemäß einem der Ansprüche 1 bis 7, bei dem die erste (2) und zweite (4) Kammstruktur einen Grundkörper (10, 11) umfassen, mit dem über ein Ende die Finger (6, 8) der ersten (2) beziehungsweise zweiten (4) Kammstruktur verbunden sind.

**9.** Element gemäß dem vorangehenden Anspruch, bei dem sich die Körper (10, 11) wenigstens zum Teil im Wesentlichen gemäß einer Achse erstrecken, die zur ersten Verschiebungsrichtung (X) parallel ist.

**10.** Element gemäß einem der Ansprüche 1 bis 9, bei dem die erste Kammstruktur (102, 202) einen im Wesentlichen rechteckigen Rahmen (105, 205) umfasst, der sich schräg in das Rahmeninnere erstreckende Finger (106, 206) umfasst, und bei dem die zweite Kammstruktur (104, 204) einen sich in die erste Richtung (X) erstreckenden Hauptarm (126, 207) umfasst, wobei sich die Finger (108, 208) der zweiten Kammstruktur (104, 204) in Fischgrätanordnung vom Hauptarm aus erstrecken.

**11.** Element gemäß dem vorangehenden Anspruch, bei dem die zweite Kammstruktur (104) auch einen Nebenarm (128) senkrecht zum Hauptarm (126) umfasst, der sich im Wesentlichen in der zweiten Richtung (Y) erstreckt, wobei sich die Finger (108) der zweiten Kammstruktur (104) ebenfalls in Fischgrätanordnung vom Nebenarm (128) aus erstrecken.

**12.** Element gemäß dem vorangehenden Anspruch, die eine die erste Richtung (X) enthaltende Symmetrieebene und eine eine zweite Richtung (Y) senkrecht zur ersten Richtung (X) enthaltende Symmetrieebene umfasst,

**13.** Element gemäß einem der vorangehenden Ansprüche, bei dem die zweite Kammstruktur in Ruhe bezüglich der ersten Kammstruktur verschoben ist.

**14.** Element gemäß einem der vorangehenden Absprüche, bei dem die Finger (102, 104) eine relative Verschiebung in die zweite Richtung (Y) aufweisen.

**15.** Element gemäß einem der Ansprüche 1 bis 13, das Führungsmittel (138, 206) umfasst, die die Verschiebung der zweiten Kammstruktur (104, 204) bezüglich der ersten Kammstruktur (102, 202) in der ersten Verschiebungsrichtung (X) gestatten.

**16.** Element gemäß dem vorangehenden Anspruch in Kombination mit Anspruch 10, 11 oder 12, bei dem die Führungsmittel (138, 216) Enden des Hauptarms (126, 207) der zweiten Kammstruktur (104, 204) mit dem Rahmen (105, 205) der ersten Kammstruktur (102, 202) verbunden.

**17.** Element gemäß Anspruch 10, 11 oder 12, bei dem der Rahmen (105) im Mittelteil seiner langen Seiten einen Finger (110') in Dreiecksform umfasst und bei dem der Nebenarm (128) der zweiten Kammstruktur (104) an jedem seiner Enden zwei bezüglich einander schräg angeordnete Finger umfasst, so dass ein Raum zum Aufnehmen des Fingers in Dreiecksform (110') des Rahmens (105) gegenüber festgelegt wird,

**18.** Element gemäß einem der vorangehenden Ansprüche, bei dem sich die Finger (306, 308) in zwei Ebenen (R1, R2) erstrecken, um so Winkel zu bilden.

**19.** Element gemäß einem der vorangehenden Ansprüche, bei dem die zweite Kammstruktur (404) Finger (408) umfasst, die sich beiderseits vom Hauptkörper (410) erstrecken, wobei die Finger der zweiten Kammstruktur mit den beiderseits des Körpers (410) angebrachten Fingern (406,1, 406.2) der ersten Kammstrukturen (402.1, 402.2) ineinandergreifen.

**20.** Element gemäß dem vorangehenden Anspruch, das zwischen den Fingern (406.1, 406.2) der ersten Kammstruktur (402. 1, 402.2) und Fingern (408) der zweiten Kammstruktur (404) eingefügte elektrostatische Spiegel (414) umfasst, um eine Verschiebung der zweiten Kammstruktur bezüglich der ersten Kammstruktur in Richtung (412) und Gegenrichtung (413) dazu zu erlauben.

**21.** Element gemäß einem der vorangehenden Ansprüche, bei dem die erste Kammstruktur ortsfest ist und die zweite Kammstruktur bezüglich der ersten Kammstruktur beweglich ist.

**22.** Element gemäß einem der vorangehenden Ansprüche, bei dem die erste Kammstruktur von der zweiten Kammstruktur elektrisch isoliert ist.

**23.** Element gemäß dem vorangehenden Anspruch, bei dem die erste und zweite Kammstruktur aus einem Isoliersubstrat bestehen.

FIG. 1

EP 1 902 453 B1

FIG. 2

EP 1 902 453 B1

FIG. 3

FIG. 4

FIG. 5

FIG. 6

FIG. 7

**EP 1 902 453 B1**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- WO 0219509 A